# EUROPEAN PATENT APPLICATION

(11) **EP 1 962 230 A1**
(43) Date of publication of application: **27.08.2008**
(21) Application number: 07124107.9
(22) Date of filing: 27.12.2007
(51) Int. Cl.: G06K 19/077

(54) **RFID tag**

(30) Priority: 23.02.2007 JP 2007044199
(71) Applicant: Fujitsu Ltd., Kawasaki-shi, Kanagawa 211-8588 (JP); Fujitsu Frontech Limited, Inagi-shi, Tokyo 206-8555 (JP)
(72) Inventor: Baba, Shunji c/o Fujitsu Limited,, Kawasaki-shi, Kanagawa 211-8588 (JP); Hashimoto, Shigeru c/o Fujitsu Frontech Limited, Tokyo 206-8555 (JP); Sugimura, Yoshiyasu c/o Fujitsu Frontech Limited, Tokyo 206-8555 (JP); Niwata, Tsuyoshi c/o Fujitsu Frontech Limited,, Tokyo 206-8555 (JP)
(74) Representative: Cooper-Rolfe, Elizabeth Louise

(57) **Abstract**

A RFID tag includes a base that extends in a predetermined longitudinal direction; an antenna for communication that is wired on the base; a circuit chip that is electrically connected to the antenna and conducts radio communication via the antenna; and a sealant that covers a top of the circuit chip and seals the circuit chip in cooperation with the base. A portion of the antenna that is exposed without being covered with the sealant extends in the width direction perpendicular to the longitudinal direction.

## Description

### BACKGROUND OF THE INVENTION

### Field of the Invention

The present invention relates to a RFID tag that exchanges information with an external device in a non-contact manner. Incidentally, the "RFID tag" employed in the present invention may be called a "RFID tag inlay" by those skilled in the art, citing that the "RFID tag" of the present invention corresponds to an inner component for a RFID tag. Alternatively, the "RFID tag" of the present invention may be called a "wireless tag."

### Description of the Related Art

Recently, there have been proposed various kinds of RFID tags that wirelessly exchange information in a non-contact manner with an external device typified by a reader/writer (see, for example, Japanese Patent Application Publication Nos. 2000-311226, 2000-200332, and 2001-351082). One type of such RFID tags has a structure in which an antenna pattern for radio communication and a circuit chip are mounted on a base sheet formed of plastic, paper, etc. Applications of the RFID tag include identification of an article by attaching the RFID tag to the article and thereby exchanging information about the article with an external device.

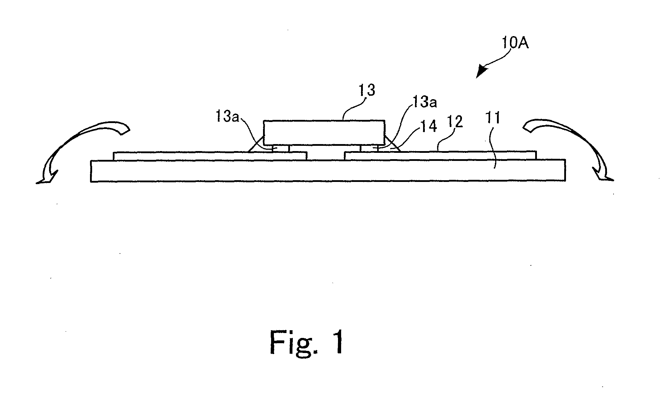

Fig. 1 shows a schematic sectional view of one example of the RFID tag.

A RFID tag 10A shown in Fig. 1 has a structure in which an antenna 12 with a conductor pattern is formed on a base 11 formed of a flexible member such as a PET film and a circuit chip 13 is mounted on the antenna 12. The circuit chip 13 incorporates a circuit for exchanging information with an external device via the antenna 12. The circuit chip 13 is electrically connected to the antenna 12 via connection terminals 13a that are formed on the undersurface of the circuit chip 13 and soldered to the antenna 12. The periphery of the circuit chip 13 is fixed onto the base 11 by using an adhesive 14.

Here, if bending stress is applied to the RFID tag 10A in the direction indicated by arrows in Fig. 1, because the hard circuit chip 13 is mounted on the flexible base 11, the circuit chip 13 may break or peel off the base 11, which may result in a malfunction of the RFID tag 10A.

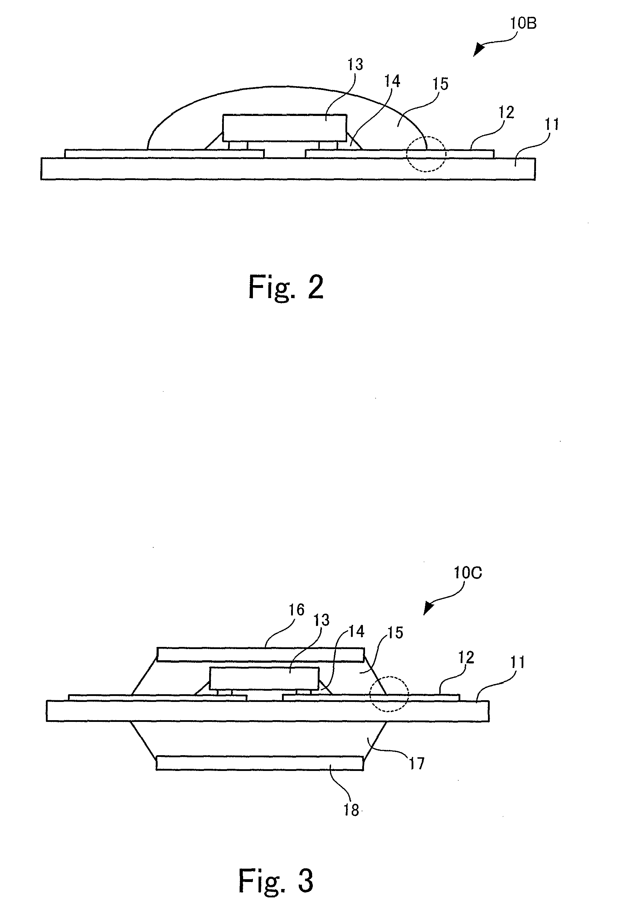

Fig. 2 is an example of another RFID tag that aims to prevent breakage or separation of a circuit chip.

Similarly to the RFID tag 10A shown in Fig. 1, a RFID tag 10B has a structure in which the antenna 12 is formed on the flexible base 11 and the circuit chip 13 is mounted and fixed onto the antenna 12 with the adhesive 14. In addition, the whole of the circuit chip 13 and part of the antenna 12 of the RFID tag 10B are covered with a potting compound 15, so that the potting compound 15 together with the base 11 seal the circuit chip 13.

In this example, because the circuit chip 13 is covered with and protected by the potting compound 15, it is possible to prevent breakage and separation of the circuit chip 13. If, however, bending stress is applied to the base 11, stress may concentrate in a portion of the antenna 12 indicated by a circle of broken lines in Fig. 2 where the antenna 12 is exposed without being covered with the potting compound 15, which may result in disconnection of the antenna 12.

Fig. 3 shows another example of a RFID tag that aims to prevent breakage and separation of a circuit chip.

A RFID tag 10C shown in Fig. 3 has a reinforcement member 16 that is disposed on and fixed by the potting compound 15, in addition to the structure of the RFID tag 10B shown in Fig. 2. Further, a reinforcement member 18 is disposed on the backside of the RFID tag 10C and fixed by a potting compound 17.

Compared with the RFID tag 10B, the RFID tag 10C of Fig. 3 prevents breakage and separation of the circuit chip 13 more surely, however, more stress is likely to concentrate in the portion of the antenna 12 indicated by a circle of broken lines in Fig. 3 that is exposed without being covered with the potting compound 15, which may result in disconnection of the antenna 12.

Here, Japanese Patent Application Publication Nos. 2000-82868 and 2006-196878 disclose the technique to prevent breaking and separation of the antenna on the flexible base. In addition, Japanese Patent Application Publication No. 2000 - 286309 discloses the technique to suppress warpage of the base. However, none of these techniques effectively solves the above problem.

### SUMMARY OF THE INVENTION

The present invention has been made in view of the above circumstances and provides a RFID tag that prevents disconnection of an antenna as well as relieves bending stress applied to a circuit chip.

A RFID tag according to the present invention includes: a base that has a belt-like shape and extends in a predetermined longitudinal direction; an antenna for communication that is wired on the base; a circuit chip that is electrically connected to the antenna and conducts radio communication via the antenna; and a sealant that covers a top of the circuit chip and seals the circuit chip in cooperation with the base, wherein a portion of the antenna that is exposed without being covered with the sealant has a shape extending in the width direction perpendicular to the longitudinal direction.

In the RFID tag of the present invention, the circuit chip is covered with the sealant. Thus, even if the base is bent, the circuit chip is free from stress, which prevents breakage and separation of the circuit chip. When the RFID tag is bent, bending stress is applied to the longitudinal direction of the base. In the RFID tag according to the present invention, however, a portion of the antenna that is exposed without being covered with the sealant extends in the width direction. Thus, even when the base is bent, stress to the exposed portion of the antenna is relieved, which prevents disconnection of the antenna.

Here, it is preferable that the RFID tag according to the present invention further includes a reinforcement member that covers the top of the circuit chip, wherein the sealant is an adhesive that fixes the reinforcement member as well as seals the circuit chip in cooperation with the base.

Presence of the reinforcement member prevents stress concentration in the circuit chip more effectively. Further, presence of the reinforcement member does not cause stress concentration in the antenna either.

As described in the above, the present invention provides the RFID tag that is capable of preventing disconnection of an antenna as well as relieving bending stress applied to a circuit chip.

### BRIEF DESCRIPTION OF THE DRAWINGS

Fig. 1 shows a schematic sectional view of an example of a conventional RFID tag;
Fig. 2 shows a sectional view of an example of a conventional RFID tag that aims to prevent breakage and separation of a circuit chip;
Fig. 3 shows a sectional view of another example of a conventional RFID tag that aims to prevent breakage and separation of a circuit chip;
Fig. 4 shows a sectional view of a conventional RFID tag as a comparative example;
Fig. 5 shows a plan view of the conventional RFID tag shown in Fig. 4;
Fig. 6 shows a sectional view of a RFID tag according to an embodiment of the present invention; and
Fig. 7 shows a plan view of the RFID tag shown in Fig. 6.

### DETAILED DESCRIPTION OF THE INVENTION

An embodiment of the present invention will be described below with reference to the drawings.

First, a comparative example with respect to the embodiment of the present invention will be described.

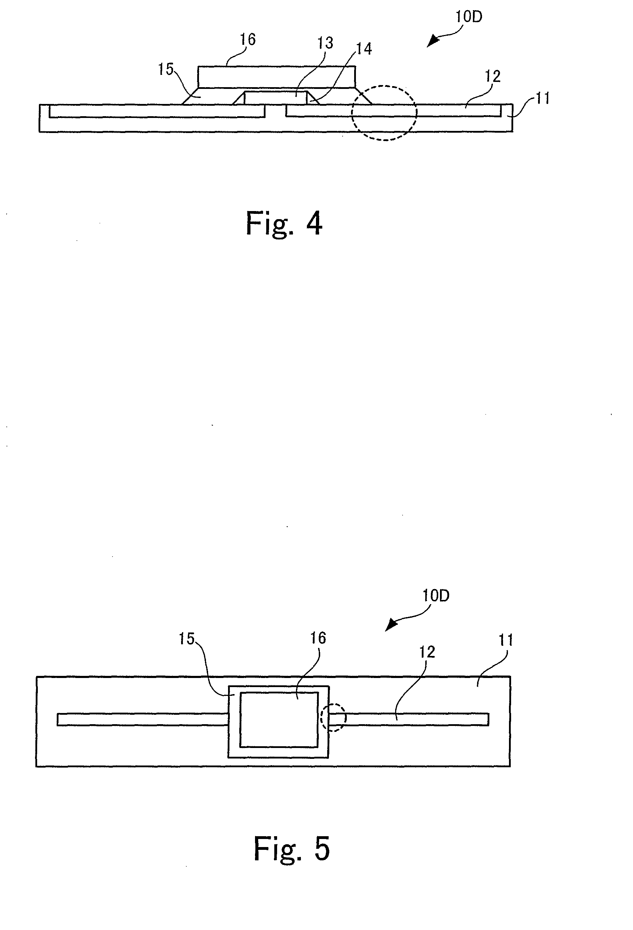

Figs. 4 and 5 respectively show a sectional view and a plan view of a RFID tag as the comparative example.

A RFID tag 10D shown in Figs. 4 and 5 has the same structure as that of the RFID tag 10C shown in Fig. 3 except that the RFID tag 10D is not provided with the potting compound 17 and the reinforcement member 18 that are formed on the back of the base 11 of the RFID tag 10C.

In other words, the RFID tag 10D has a structure in which the circuit chip 13 is mounted on the antenna 12 formed on the flexible base 11 and is fixed with the adhesive 14. The fixed chip 13 is further covered with the potting compound 15 and the reinforcement member 16 that is fixed with the potting compound 15.

The antenna 12 extends linearly in the longitudinal direction of the base 11 as shown in Fig. 5.

With the structure of the RFID tag 10D, when the base 11 is bent, stress likely concentrates in a portion of the antenna 12 (indicated by a broken-line circle in Figs. 4, 5) that is exposed without being covered with the potting compound 15, which may lead to separation of the antenna 12 from the base 11 and disconnection of the antenna 12.

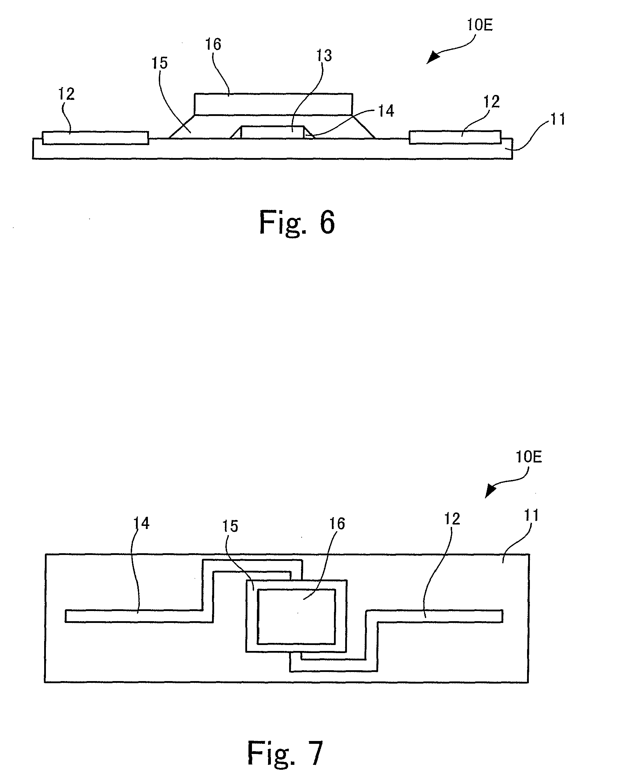

Figs. 6 and 7 respectively show a sectional view and a plan view of a RFID tag according to the embodiment of the present invention.

A RFID tag 10E of Figs. 6,7 has the similar structure to that of the RFID tag 10D of Figs. 4,5 except that the antenna 12 of the RFID tag 10E has a shape different from that of the RFID tag 10D.

The base 11 of the RFID tag 10E extends in a predetermined longitudinal direction (i.e., lateral direction in the drawing) similarly to the comparative example in Figs. 4,5, and the antenna 12 extends in the longitudinal direction in the same manner as the base 11. However, the portion of the antenna 12 that is exposed without being covered with the potting compound 15 extends in the width direction perpendicular to the longitudinal direction. As the base 11 is bent in the longitudinal direction, stress does not concentrate in the exposed portion of the antenna 12 that extends in the width direction perpendicular to the longitudinal direction. Thus, disconnection of the antenna 12 can be prevented. In addition, since the top of the circuit chip 13 of the RFID tag 10E is covered with the potting compound 15, the potting compound 15 in cooperation with the base 11 seal the circuit chip 13. Thus, it is possible to prevent stress from concentrating in the circuit chip 13 and thus to prevent breakage and separation of the circuit chip 13. Further, since the RFID tag 10E of this embodiment shown in Figs. 6 and 7 has the reinforcement member 16 that is disposed on the circuit chip 13 and fixed with the potting compound 15, stress concentration in the circuit chip 13 is more surely prevented. In this embodiment, a thermosetting adhesive, for example, is used for the potting compound 15 that fixes the reinforcement member 16 as well as seals the circuit chip 13 in cooperation with the base 11.

Incidentally, although the RFID tag 10E in this embodiment is provided with the reinforcement member 16, the potting compound 15 may be provided alone without the reinforcement member 16 (see Fig. 2), as long as the exposed portion of the antenna 12 without being covered with the potting component extends in the width direction.

## Claims

1. A RFID tag comprising:
a base that has a belt-like shape and extends in a predetermined longitudinal direction;
an antenna for communication that is wired on the base;
a circuit chip that is electrically connected to the antenna and conducts radio communication via the antenna; and
a sealant that covers a top of the circuit chip and seals the circuit chip in cooperation with the base,
wherein a portion of the antenna that is exposed without being covered with the sealant has a shape extending in the width direction perpendicular to the longitudinal direction.

2. The RFID tag according to claim 1, further comprising a reinforcement member that covers the top of the circuit chip,
wherein the sealant is an adhesive that fixes the reinforcement member as well as seals the circuit chip in cooperation with the base.
